# EUROPEAN PATENT APPLICATION

(11) **EP 1 429 184 A1**
(43) Date of publication of application: **16.06.2004**
(21) Application number: 03257823.9
(22) Date of filing: 12.12.2003
(51) Int. Cl.: G03F 7/038, G03F 7/033

(54) **Functionalized copolymer for photopolymerizable composition**

(30) Priority: 12.12.2002 US 432875 P
(71) Applicant: Shipley Company, L.L.C., Marlborough, MA 01752 (US)
(72) Inventor: Anzures, Edgardo, Westborough Massachusetts 01581 (US); Barr, Robert K., Shrewsbury Massachusetts 01545 (US); Fu, Yueping, Shrewsbury Massachusetts 01545 (US)
(74) Representative: Kent, Venetia Katherine

(57) **Abstract**

A functionalized copolymer containing a main chain derived from polymerizable monomers and pendent functional groups terminated with one or more α or β ethylenically or acetylenically unsaturated groups. The functionalized copolymers are self cross-linking and are suitable for use as binders.

## Description

### Background of the Invention

The present invention is directed to a functionalized polymer. More specifically, the present invention is directed to a functionalized polymer that improves the performance of photosensitive compositions.

Polymers are employed for numerous purposes in a wide variety of industries. Such industries include lithography, optical data storage, decorative pigments, adhesives, cosmetics, security applications or active and passive optical elements such as polarizers, optical retarders or color filters, and electrophotographic imaging members.

In lithography, polymers are employed in photopolymerizable compositions such as photoresists. Polymers may function as a binder for photoresist compositions. Other components of photoresists include cross-linking monomers that cross-link after exposure to actinic radiation, and photoinitiators. Photoinitiators initiate the cross-linking reaction between the cross-linking monomers upon light exposure. Other additives included in photoresists include anti-striation reagents, plasticizers, speed enhancers, fillers, dyes, and the like. Because polymer binders compose a majority of a photoresist, a photoresist derives most of its properties from the polymer binder fraction.

Photoresists may be primary photoimaging resists or secondary photoimaging resists. Primary photoresists are used to form temporary coatings on substrates. Secondary photoresists are hardenable and form permanent layers, e.g., solder masks. Photoresists are used to make printed circuits, printing plates, solder masks and the like. Photoresists have various requisites such as etching resistance, heat resistance, adhesion and developable in developer solutions such as highly alkaline solutions. However, the lithographic industry has found that the synthesis of a polymer that may be employed in a photoresist and that satisfies all of the requisites for a photoresist is difficult. For example, a polymer having a polyacrylate main chain or backbone can be easily synthesized, but such a polymer has poor etching resistance and has difficulties in the developing process. In order to secure etching resistance, workers in the art have considered adding an alicyclic unit to the main chain. However, to form such a copolymer is difficult.

As the technology level of printed circuit boards increases towards finer lines/spaces, the demand placed on the photoresist materials used to produce such boards becomes greater. This in turn places a greater burden on the photoresist formulator to accommodate improved performance, without a decrease in production level or an increase in manufacturing cost of the photoresist product. Similar considerations apply for use of photopolymerizable compositions in proofing and flexographic printing.

For use in the manufacture of printed circuit boards having fine lines/spaces, it is critical that the photoresist used posses properties such that, upon imaging, the exposed and developed photoresist affords photoresist patterns having good sidewall geometry (i.e., sidewalls are smooth, planar and form an angle of 90° with respect to the substrate surface, and are free of imperfections such as mousebites, gouges, foots, etc.). Photoresists that afford good sidewall geometry perform better in printed circuit board manufacture than otherwise comparable photoresists that do not afford good sidewall geometry. Photoresists that do afford good sidewall geometry exhibit higher resolution, are useful in production of finer line/space printed circuit boards, and give fewer defects and higher yields in printed circuit board manufacture.

Circuit lines and spaces on circuit boards have continued to shrink as more circuitry needs to be fit onto smaller surfaces. At the same time, metal plating heights have increased above the thickness of the photoresist. This causes the metal to hang over the photoresist resulting in a very narrow space containing the photoresist being encapsulated by metal overplating. The photoresist may then be trapped by the plated overhang and stripping is made difficult. If the photoresist is not stripped clean, ragged metal circuit lines result after etching which are unusable. Such circuit lines can cause short-circuiting on the board.

Some manufacturers have tried thicker photoresists to accommodate the increasing plating heights. However, such an approach is more expensive and limits resolution of the circuit lines. Many manufacturers use organic-based (amine- or organic solvent-containing) alkaline stripping solutions that produce a smaller stripped particle to facilitate stripping. While the organic strippers, e.g., solutions containing trimethylamine or tetramethylammonium hydroxide, remove the photoresist, such strippers are expensive relative to alkaline aqueous strippers (sodium hydroxide and potassium hydroxide), and have more waste treatment and environmental concerns associated with them. Further, due to emphasis in the industry on reducing solvent emissions in the workplace, solvent-strippable photoresists are much less desirable than the aqueous-strippable. Accordingly, there is a need for improved primary imaging photoresists.

Secondary imaging photoresists also suffer from a number of problems. To best serve their intended purpose, secondary imaging photoresists such as solder masks desirably exhibit a high degree of chemical resistance to solder and the fluxes used in soldering operations. Solder masks also desirably have a high degree of thermal resistance relative to the elevated temperatures used in soldering operations. Many solder masks produced from photosensitive compositions are deficient in these regards, having tendencies to degrade, blister or separate from circuit boards under conditions of soldering applications. Yet other photosensitive resin compositions produce solder masks that are excessively brittle with increased tendency to chip and flake under conditions encountered in handling and processing of circuit boards on which they are arranged. Attempts at solving such problems often are counter-productive, i.e., generating problems associated with the photosensitive composition itself such as premature curing, instability, short shelf-life and the like.

Instability of a photoresist composition results in a short shelf-life. Instability may result from the cross-linking monomers included in the photoresist composition. Prior to exposure of a photoresist composition to actinic radiation, each monomer is a potential reactant with another monomer. If not properly stored or when the photoresist is prematurely exposed to a radiation source, the monomers may prematurely react, thus spoiling the composition and reducing shelf-life. Also, after exposure of the photoresist composition to actinic radiation, a fair proportion of the cross-linking monomers may not react. The photopolymerization process never reaches 100% conversion, thus there is always free monomer existing in cured states. Improper curing of the photoresist may occur resulting in brittle or poorly chemically resistant photoresist.

Unreacted monomers also may migrate through cover sheets composed of polyethylene to polyethylene/polyester interface of a dry film roll. Such unreacted monomers may act as a lubricant at the interface and cause slippage and distortion. The monomers may plasticize the photoresist resulting in edge fusion of the dry film rolls. Since the monomer may be on the cover sheet, there is a chance for human contact with such monomers, thus presenting a health hazard to workers handling the dry film. Art work used in the imaging steps also may be contaminated with unreacted monomer which presents another avenue of worker contact with the monomers. Unreacted monomers also may leach into various processing solutions, such as plating solutions, to adversely affect the performance of the solutions. Additionally, monomers may cause scum and residue formation in developer and/or stripper solutions as well as on equipment.

Waste treatment of photoresist is another problem. Conventional waste treatment schemes involve a process in which the pH of the waste stream is lowered by the addition of acid. This causes pH-sensitive materials such as the polymer binder of the photoresist to precipitate out of solution for easy disposal. However, monomers are typically not as pH-sensitive as polymers and as a result are more difficult to treat than the polymer binders, thus presenting an environmental hazard.

Formulation of a primary imaging photoresist and a secondary imaging photoresist involves a careful balancing of factors, often seemingly inconsistent, in order to attain desirable properties in the photoresist and to address the numerous foregoing problems. As mentioned above photoresists contain numerous components such as polymer binders, various monomers, photoinitiators, dyes and other additives. Because polymer binders compose a majority of the photoresist, a photoresist derives most of its properties from the polymer binder fraction.

U.S. 5,962,190 and U.S. 6,180,323 both to McKeever disclose a photoresist which allegedly has improved sidewall geometry and broad development latitude due to the polymer binder. However, McKeever does not address such parameters as improved line adhesion with faster stripping ability, or reduced scum and residue formation. Typically, good fine line adhesion is sacrificed for faster stripping. Accordingly, there is a need for a polymer that improves stripping ability of photoimageable compositions with aqueous strippers, provides good adhesion, and provides a stable photoresist composition to improve shelf-life.

### Summary of the Invention

A compound which includes a backbone having a formula:

(A)ᵤ (B)ᵥ (C)_{w} (D)ₓ (E)_{y} (F)_{z} (I)

where A is derived from one or more hydroxyalkyl (meth)acrylate, B is derived from one or more hydroxy polyalkyleneoxide (meth)acrylate, C is derived from one or more alkyl(meth)acrylate, D is derived from one or more (meth)acrylic acid, E is derived from one or more vinyl aromatic monomer, nitrogen containing compound or thio-analog of a nitrogen containing compound, silicon containing monomer, substituted ethylene monomer, or cyclic olefin monomer, and F is derived from one or more hydroxy poly opened-ring lactone polyalkylene oxide (meth)acrylate, where u, v, w, x, y and z are weight percentages of the monomers in the backbone, where u is 0 to 30%, v is 0 to 30%, w is 5 to 70%, x is 5 to 40%, y is 0 to 20% and z is 0 to 30% with the proviso that at least one of u, v or z is greater than 0, and at least one of A, B, C, D, E and F has at least one pendent functional group.

The present invention also is directed to a photopolymerizable composition which includes a polymeric binder having a formula:

(A)ᵤ (B)ᵥ (C)_{w} (D)ₓ (E)_{y} (F)_{z} (I)

where A is derived from one or more hydroxyalkyl (meth)acrylate, B is derived from one or more hydroxy polyalkyleneoxide (meth)acrylate, C is derived from one or more alkyl(meth)acrylate, D is derived from one or more (meth)acrylic acid, E is derived from one or more vinyl aromatic monomer, nitrogen containing compound or thio-analog of a nitrogen containing compound, silicon containing monomer, substituted ethylene monomer, or cyclic olefin monomer, and F is derived from one or more hydroxy poly opened-ring lactone polyalkylene oxide (meth)acrylate, where u, v, w, x, y and z are weight percentages of the monomers in the backbone, where u is 0 to 30%, v is 0 to 30%, w is 5 to 70%, x is 5 to 40%, y is 0 to 20% and z is 0 to 30% with the proviso that at least one of u, v or z is greater than 0, and at least one of A, B, C, D, E and F has at least one pendent functional group; and a photoinitiator. Optionally, the photopolymerizable composition may include at least one ethylenically unsaturated monomer as a cross-linking agent.

In another aspect, the present invention is directed to a method of imaging which includes the steps of (1) providing a photopolymerizable composition which includes a compound having a formula:

(A)ᵤ (B)ᵥ (C)_{w} (D)ₓ (E)_{y} (F)_{z} (I)

where A is derived from one or more hydroxyalkyl (meth)acrylate, B is derived from one or more hydroxy polyalkyleneoxide (meth)acrylate, C is derived from one or more alkyl(meth)acrylate, D is derived from one or more (meth)acrylic acid, E is derived from one or more vinyl aromatic monomer, nitrogen containing compound or thio-analog of a nitrogen containing compound, silicon containing monomer, substituted ethylene monomer, or cyclic olefin monomer, and F is derived from one or more hydroxy poly opened-ring lactone polyalkylene oxide (meth)acrylate, where u, v, w, x, y, and z are weight percentages of the monomers in the backbone, where u is 0 to 30%, v is 0 to 30%, w is 5 to 70%, x is 5 to 40%, y is 0 to 20% and z is 0 to 30% with the proviso that at least one of u, v or z is greater than 0, and at least one of A, B, C, D, E and F has at least one pendent functional group; optionally, at least one ethylenically unsaturated monomer; and a photoinitiator; (2) applying the photopolymerizable composition to a substrate; (3) imagewise exposing the photopolymerizable composition to actinic radiation to form a polymerized composition; and (4) developing the imagewise exposed photopolymerized composition to form an image on the substrate.

Surprisingly, the present invention provides for a photopolymerizable composition having improved fine line adhesion with faster stripping, and faster strip time with smaller strip mode. Such improvements do not typically occur together in photopolymerizable compositions.

Another advantage of the present invention is the elimination or at least reduction in the amount of ethylenically unsaturated monomers that are used in the photopolymerizable composition as cross-linking agents. Photopolymerization processes do not reach 100% conversion. Accordingly, there is free monomer in the cured state of the composition. Such monomers may migrate through cover sheets on which a photopolymerizable composition is laminated. The monomer may then act as a lubricant causing roll slippage and distortion in a dry film. Additionally, workers may be exposed to the monomers that have migrated through the cover sheets presenting a toxic hazard. Such migration of monomers may also contaminate artwork employed in lithography. Monomers also may leach into various processing solutions such as developer and stripping solutions during the manufacture of printed wiring boards and adversely affect the performance of the solutions and the quality of the boards. They also may plasticize dry film photopolymerizable compositions resulting in edge fusion in a dry film roll. Accordingly, the present invention eliminates or at least reduces the foregoing problems encountered with monomers.

Also, compositions that have reduced monomer content are easier to waste treat. Conventional waste treatment schemes involve a process in which the pH of the waste treatment stream is lowered by the addition of acid. This causes pH sensitive materials such as polymer binders to precipitate out of solution. The resultant solution becomes clear and free of waste. Monomers typically are not as pH sensitive as polymer binders and as a result are more difficult to treat than polymers. Further, elimination or reduction of monomers eliminates or at least reduces scum and residue formation. Accordingly, the present invention provides for a more environmentally friendly composition.

A primary objective of the present invention is to provide an improved functionalized polymer.

Another objective of the present invention is to provide a functionalized polymer that can act as the sole cross-linking component in a photopolymerizable composition.

An additional objective of the present invention is to provide for a water-soluble or water-emulsifiable binder polymer for photopolymerizable compositions.

A further objective of the present invention is to provide for a photoresist composition having improved fine line adhesion with faster stripping, and faster stripping with smaller strip mode.

Other objectives and advantages of the invention may be ascertained by a person of skill in the art upon reading the description of the invention and the appended claims.

### Detailed Description of the Invention

A "moiety" within the scope of the present invention means a distinct structural component of a functionlized polymer and is synonymous with the term "group". The term "polymer" means both polymer and copolymer. "Pendent" means a structural component of the functionalized polymer that is joined to or suspended from the main chain or backbone of the functionalized polymer by a chemical bond. "(Meth)acrylate" means both acrylate and methacrylate and (meth)acrylic means both acrylic and methacrylic. "Monomer" means any ethylenically or acetylenically unsaturated compound that may be polymerized.

The present invention is directed to a compound having a backbone with pendent functional groups, a photopolymerizable composition including the compound having a backbone and functional pendent groups, and a method of producing an image on a substrate using the photopolymerizable composition. Surprisingly, the photopolymerizable composition has improved resolution with improved fine line adhesion, fine line adhesion with faster stripping and faster stripping with a smaller strip mode. Typically a photopolymerizable composition with good resolution has decreased fine line adhesion, and with good fine line adhesion the rate of stripping is compromised. Also, when stripping is improved the strip mode typically increases. The foregoing problems are addressed by a compound having a formula:

(A)ᵤ (B)ᵥ (C)_{w} (D)ₓ (E)_{y} (F)_{z} (I)

where A is derived from one or more hydroxyalkyl (meth)acrylate, B is derived from one or more hydroxy polyalkylene oxide (meth)acrylate, C is derived from one or more alkyl(meth)acrylate, D is derived from one or more (meth)acrylic acid, E is derived from one or more vinyl aromatic monomer, nitrogen containing compounds or thio-analogs of nitrogen containing compounds, silicon containing monomer, substituted ethylene monomer, or cyclic olefin monomer, and F is derived from one or more hydroxy poly opened-ring lactone polyalkylene oxide (meth)acrylate, to compose the backbone of the compound or polymer, where u, v, w, x, y and z are weight percentages of monomers in the backbone, u is 0 to 30%, v is 0 to 30%, w is 5 to 70%, x is 5 to 40%, y is 0 to 20% and z is 0 to 30% with the proviso that at least one or u, v or z is greater than 0, and at least one of A, B, C, D, E and F has at least one pendent functional group. The sum of u, v, w, x, y and z for a given polymer is 100% by weight.

The polymers of the present invention are 15% to 70% (mole %) hydroxyl capped. Hydroxyl capped, within the scope of the present invention, refers to the mole percent of free or unreacted hydroxyl groups or moieties on the polymer backbone. Mole percent of a polymer is determined by infrared analysis or determined by the amount of each starting material. Such methods are well known in the art. Hydroxyl capping provides for a polymer that may react with another compound to form a functional polymer as discussed below. Hydroxyl capping also provides for a water-soluble or water-emulsifiable compound.

Hydroxyalkyl (meth)acrylate monomers that may be employed to prepare the polymer include, but are not limited to, hydroxyalkyl (meth)acrylates with one or more hydroxyl groups in the alkyl radical, especially those where the hydroxyl group is found at the β-position (2-position) in the alkyl radical. Hydroxyalkyl (meth)acrylate monomers in which the substituted alkyl group is a (C₂-C₆)alkyl, branched or unbranched, are preferred. Suitable hydroxyalkyl (meth)acrylate monomers include, but are not limited to, 2-hydroxyethyl methacrylate ("HEMA"), 2-hydroxyethyl acrylate ("HEA"), 2-hydroxypropyl methacrylate, 1-methyl-2-hydroxyethyl methacrylate, 2-hydroxypropyl acrylate, 1-methyl-2-hydroxyethyl acrylate, 2-hydroxybutyl methacrylate, 2-hydroxybutyl acrylate or mixtures thereof. Preferred hydroxyalkyl (meth)acrylate monomers are HEMA, 1-methyl-2-hydroxyethyl methacrylate, 2-hydroxypropyl methacrylate and mixtures thereof. A mixture of the latter two monomers is commonly referred to as "hydroxypropyl methacrylate" or "HPMA".

Suitable hydroxy polyalkylene oxide (meth)acrylates and hydroxy poly opened-ring lactone polyalkylene oxide (meth)acrylates may be prepared from poly(propylene glycol) (meth)acrylates, poly(propylene glycol) alkyl ether (meth)acrylates, poly (propylene glycol) phenyl ether (meth)acrylates, poly(propylene glycol) 4-nonylphenol ether (meth)acrylates, poy(ethylene glycol) (meth)acrylates, poly(propylene/ethylene glycol) (meth)acrylates, poly(ethylene glycol)alkyl ether (meth)acrylates, poly(ethylene glycol) phenyl ether (meth)acrylates, poly(propylene/ethylene glycol) alkylether (meth)acrylates and mixtures thereof. The poly(alkylene oxide) may have from 1 to 50 degrees of polymerization. Examples of such compounds are disclosed in formula (V) below. Such compounds may also be joined to the polymer backbone as a pendent functional group via an isocyanate group as described below.

Alkyl (meth)acrylates useful in the present invention may be a single monomer or a mixture having different numbers of carbon atoms in the alkyl portion. Examples of alkyl (meth)acrylates useful in the present invention are (C₁-C₂₄)alkyl (meth)acrylates. Suitable alkyl (meth)acrylates include, but are not limited to, "low cut" alkyl (meth)acrylates, "mid cut" alkyl (meth)acrylates and "high cut" alkyl (meth)acrylates.

"Low cut" alkyl (meth)acrylates are those where the alkyl group contains from 1 to 6 carbon atoms. Suitable low cut alkyl (meth)acrylates include, but are not limited to: methyl methacrylate, methyl acrylate, ethyl acrylate, propyl methacrylate, butyl methacrylate, butyl acrylate, isobutyl methacrylate, hexyl methacrylate, cyclohexyl methacrylate, cyclohexyl acrylate and mixtures thereof. Such low cut alkyl (meth)acrylates are preferred, especially those with 3 to 5 carbon atoms in the alkyl group. A most preferred low cut alkyl(meth)acrylate is n-butyl acrylate. Surprisingly, such alkyl (meth)acrylates, provide for a composition that has faster development time without a change in strip time, and helps to reduce scum and residue build-up in developer solutions.

"Mid cut" alkyl (meth)acrylates are those where the alkyl group contains from 7 to 15 carbon atoms. Suitable mid cut alkyl (meth)acrylates include, but are not limited to: 2-ethylhexyl acrylate ("EHA"), 2-ethylhexyl methacrylate, octyl methacrylate, decyl methacrylate, isodecyl methacrylate (based on branched (C₁₀)alkyl isomer mixture), undecyl methacrylate, dodecyl methacrylate (also known as lauryl methacrylate), tridecyl methacrylate, tetradecyl methacrylate (also known as myristyl methacrylate), pentadecyl methacrylate and mixtures thereof. Particularly useful mixtures include dodecyl-pentadecyl methacrylate, a mixture of linear and branched isomers of dodecyl, tridecyl, tetradecyl and pentadecyl methacrylates; and lauryl-myristyl methacrylate.

"High cut" alkyl (meth)acrylates are those where the alkyl group contains from 16 to 24 carbon atoms. Suitable high cut alkyl (meth)acrylates include, but are not limited to: hexadecyl methacrylate, heptadecyl methacrylate, octadecyl methacrylate, nonadecyl methacrylate, cosyl methacrylate, eicosyl methacrylate and mixtures thereof. Particularly useful mixtures of high cut alkyl (meth)acrylates include, but are not limited to: cetyl-eicosyl methacrylate, which is a mixture of hexadecyl, octadecyl, cosyl and eicosyl methacrylate; and cetyl-stearyl methacrylate, which is a mixture of hexadecyl and octadecyl methacrylate.

The mid-cut and high-cut alkyl (meth)acrylate monomers described above may be prepared by standard esterification procedures using technical grades of long chain aliphatic alcohols, and these commercially available alcohols are mixtures of alcohols of varying chain lengths containing between 10 and 15 or 16 and 20 carbon atoms in the alkyl group. Examples of these alcohols are the various Ziegler catalyzed ALFOL alcohols from Vista Chemical company, i.e., ALFOL 1618 and ALFOL 1620, Ziegler catalyzed various NEODOL alcohols from Shell Chemical Company, i.e. NEODOL 25L, and naturally derived alcohols such as Proctor & Gamble's TA-1618 and CO-1270. Consequently, for the purposes of this invention, alkyl (meth)acrylate is intended to include not only the individual alkyl (meth)acrylate product named, but also to include mixtures of the alkyl (meth)acrylates with a predominant amount of the particular alkyl (meth)acrylate named.

Suitable nitrogen-containing monomers are (meth)acrylamides. (Meth)acrylamides of the present invention may optionally be substituted. Suitable optionally substituted (meth)acrylamide monomers include, but are not limited to, dialkylamino (C₂-C₂₀)alkyl (meth)arylates, dialkaylamino (C₂-C₂₀)alkyl (meth)acrylamides, preferably, dialkylamino(C₂-C₆)alkyl (meth)acrylates, dialkylamino(C₂-C₆)alkyl (meth)acrylamides.

Other suitable nitrogen-containing monomers useful to prepare the polymer are those with an amino group or alkylamino group. Examples include, but are not limited to: methylaminoethyl methacrylate, methylaminoethyl acrylate, N-methylaminoethyl methacrylamide, N-methyl-aminopropyl methacrylamide, N-methylaminobutyl methacrylamide, N-ethylaminoethyl methacrylamide, N-ethylaminopropyl methacrylamide, N-ethylaminobutyl methacrylamide, N-(1,1-dimethyl-3-oxobutyl) acrylamide, N-(1,3-diphenyl-1-ethyl-3-oxobutyl) acrylamide, N-(1-methyl-1-phenyl-3-oxobutyl) methacrylamide, and 2-hydroxyethyl acrylamide, N-methacrylamide of aminoethyl ethylene urea, N-maleimide of dimethylaminopropylamine and mixtures thereof.

Additional nitrogen-containing compounds and their thio-analogs useful as unsaturated monomers to prepare the polymer include, but are not limited to: vinylpyridines such as 2-vinylpyridine or 4-vinylpyridine; (C₁-C₈)alkyl substituted N-vinyl pyridines such as 2-methyl-5-vinyl-pyridine, 2-ethyl-5-vinylpyridine, 3-methyl-5-vinylpyridine, 2,3-dimethyl-5-vinyl-pyridine, and 2-methyl-3-ethyl-5-vinylpyridine; methyl-substituted quinolines and isoquinolines; N-vinylcaprolactam; N-vinylbutyrolactam; N-vinylpyrrolidone; vinyl imidazole; N-vinyl carbazole; N-vinyl-succinimide; (meth)acrylonitrile; *o-, m-,* or *p*-aminostyrene; hydroxystylene; maleimide; N-vinyl-oxazolidone; N,N-dimethyl aminoethyl-vinyl-ether; ethyl-2-cyano acrylate; vinyl acetonitrile; N-vinylphthalimide; N-vinyl-pyrrolidones such as N-vinyl-thio-pyrrolidone, 3-methyl-1-vinyl-pyrrolidone, 4-methyl-1-vinyl-pyrrolidone, 5-methyl-1-vinyl-pyrrolidone, 3-ethyl-1-vinyl-pyrrolidone, 3-butyl-1-vinyl-pyrrolidone, 3,3-dimethyl-1-vinyl-pyrrolidone, 4,5-dimethyl-1-vinyl-pyrrolidone, 5,5-dimethyl-1-vinyl-pyrrolidone, 3,3,5-trimethyl-1-vinyl-pyrrolidone, 4-ethyl-1-vinyl-pyrrolidone, 5-methyl-5-ethyl-1-vinyl-pyrrolidone and 3,4,5-trimethyl-1-vinyl-pyrrolidone; vinyl pyrroles; vinyl anilines; and vinyl piperidines.

Other monomers useful in the present invention are silicon-containing monomers such as γ-propyl tri(C₁-C₆)alkoxysilyl (meth)acrylate, γ-propyl tri(C₁-C₆)alkylsilyl (meth)acrylate, γ-propyl di(C₁-C₆)alkoxy(C₁-C₆)alkylsilyl (meth)acrylate, γ-propyl di(C₁-C₆)alkyl(C₁-C₆)alkoxysilyl (meth)acrylate, vinyl tri(C₁-C₆)alkoxysilyl (meth)acrylate, vinyl di(C₁-C₆)alkoxy(C₁-C₆)alkylsilyl (meth)acrylate, vinyl (C₁-C₆)alkoxydi(C₁-C₆)alkylsilyl (meth)acrylate, vinyl tri(C₁-C₆)alkylsilyl (meth)acrylate, 2-propylsilsesquioxane (meth)acrylate and mixtures thereof.

The vinyl aromatic monomers useful as unsaturated monomers in the present invention include, but are not limited to: styrene, hydroxystyrene, α-methylstyrene, vinyltoluene, *p*-methylstyrene, ethylvinylbenzene, vinylnaphthalene, vinylxylenes, and mixtures thereof. The vinylaromatic monomers also include their corresponding substituted counterparts, such as halogenated derivatives, i.e., containing one or more halogen groups, such as fluorine, chlorine or bromine; and nitro, and cyano.

The substituted ethylene monomers useful as unsaturated monomers in the present invention include, but are not limited to: vinyl alcohols, vinyl acetate, vinyl formamide, vinyl chloride, vinyl fluoride, vinyl bromide, vinylidene chloride, vinylidene fluoride, vinylidene bromide, tetrafluoroethylene, trifluoroethylene, trifluoromethyl vinyl acetate, vinyl ethers and itaconic anhydride.

Suitable cyclic olefin monomers useful in the present invention are (C₅-C₁₀) cyclic olefins, such as cyclopentene, cyclopentadiene, dicylopentene, cyclohexene, cyclohexadiene, cycloheptene, cycloheptadiene, cyclooctene, cyclooctadiene, norbornene, maleic anhydride and the like. Such cyclic olefins also include spirocyclic olefin monomers such as spirocyclic norbornenyl monomers, spirocyclic cyclohexene monomers, spirocyclic cyclopentene monomers and mixtures thereof. Suitable substituted cyclic olefin monomers include, but are not limited to, cyclic olefins having one or more substituent groups selected from hydroxy, aryloxy, halo, (C₁-C₁₂)alkyl, (C₁-C₁₂)haloalkyl, (C₁-C₁₂)hydroxyalkyl, or (C₁-C₁₂)halohydroxyalkyl. Particularly suitable substituted cyclic olefins include maleic anhydride and cyclic olefins containing one or more of hydroxy, aryloxy, (C₁-C₁₂)alkyl, (C₁-C₁₂)haloalkyl, (C₁-C₁₂)hydroxyalkyl, (C₁-C₁₂)halohydroxyalkyl, carbo(C₁-C₂₀)alkoxy, and carbo(C₁-C₂₀)haloalkoxy.

The molecular weight of the polymer backbone may range from 1,000 to 30,000 daltons. The polymer backbone may be made by any suitable method in the art such as free-radical polymerization. For example, monomers chosen from the list above are dissolved in an appropriate solvent and heated in a reaction vessel in the presence of a thermal free radical initiator to initiate polymerization. Examples of suitable initiators include, but are not limited to, peroxide compounds, such as dibenzoyl peroxide, and azo compounds, such as 2,2'-azobis(2-methylpropanenitrile), 2,2'-azobis(2-methylbutanenitrile), 2,2'-azobis(2,4-dimethylethylpentanenitrile), and 1,1'-azobis(cyclohexanecarbonitrile).

Functional polymers within the scope of the present invention may be prepared by a post polymerization functionalization process. In post polymerization functionalization, the main chain or backbone and the functional pendent components are prepared separately. After the preparation of each of the separate components that make up the polymer are prepared, they are then joined together in a separate reaction process to form the final functionalized polymer product.

After the polymer is prepared, the free hydroxyl groups or aminyl groups on the polymer are bonded with a compound that has at least one α,β-ethylenically or acetylenically unsaturated group or another reactive group to form a functional group pendent from the polymer backbone. Reactions of the hydroxyl group may involve the breaking of the O―H bond with removal of hydrogen in which a group replaces the hydrogen. Aminyl groups on the polymer backbone may be joined to compounds with functional groups by known amine reactions such as conversion into amides. Any compound that may react with the hydroxyl or aminyl group of the polymer and has at least one unsaturated group or another reactive group may be employed. The unsaturated group enables the polymer to cross-link with another polymer when exposed to actinic radiation. Additional reactive groups of the pendent functional group which do not react with the hydroxyl or aminyl groups from the polymer backbone may react with other compounds to extend and modify the functional pendent groups. The functional pendent groups permit the reduction or elimination of cross-linking agents in photopolymerizable compositions.

An example of a reactive group that may react with a hydroxyl or aminyl group of the polymer backbone is the isocyanate group (i.e.-N=C=O). The polymer backbone may be mixed with an isocyanate compound at reaction temperatures below 80° C. Preferably, reaction temperatures are run at mild temperatures of from 20° C to 60° C. Mixing and heating are continued until the reaction is complete. Typically, the reaction continues for 1 hour to less than 8 hours, preferably from 4 to 6 hours. Advantageously, the method of the present invention is performed over short time periods, thus less energy is utilized in preparing the functionalized polymer than conventional methods. Reactions that take place occur between a free isocyanate group on the isocyanate compound and a hydroxyl group, carboxyl group, or primary or secondary aminyl functional group attached to the polymer main chain or backbone. One mole of free isocyanate react with one mole of a hydroxyl, carboxyl, or primary or secondary aminyl on the polymer main chain. The reaction may be self-quenching. There is believed to be no source of free radicals, or a source of cations or anions at the end of the reaction between the isocyanate group(s) and hydroxyl, carboxyl, or aminyl group(s) on the polymer backbone. As a precaution water, alcohol, or other chemical species with labile hydrogen, and a suitable catalyst, such as triethylamine, may be added at the end of the reaction to quench any free isocyanate. Also, a suitable polymerization inhibitor may optionally be added to prevent premature cross-linking of terminal ethylenically or acetylenically unsaturated moieties such as a (meth)acrylate moiety. Reaction completion may be determined by using standard analytical instruments well known in the art.

The methods according to the present invention may be carried out in the presence of an inert dry solvent, for example, an ether such as diisopropyl ether, ethylene glycol dimethyl ether, diethylene glycol dimethyl ether, 1,4-dioxane, tetrahydrofuran or 1,2-dimethoxy propane; an ester such as butyrolactone, ethylene glycol carbonate or propylene glycol carbonate; an ether ester such as methoxyethyl acetate, ethoxyethyl acetate, 1-methoxypropyl-2-acetate, 2-methoxypropyl-1-acetate, 1-ethoxypropyl-2-acetate or 2-ethoxypropyl-1-acetate; ketones such as acetone or methyethyl ketone; nitriles such as acetonitirle, propionitrile or methoxypropionitrile; sulfones such as sulfolan, dimethylsulfone or diethylsulfone; and phosphoric acid esters such as trimethyl phosphate or triethyl phosphate. The processes may also be carried out without such solvents.

To accelerate the reactions of the methods of the present invention, any suitable catalyst employed in polymerization reactions can be used. Tin containing catalysts are preferred, such as dibutylin dilaurate, tin(II) octoate or dibutylin dimethoxide. Such catalysts are employed in an amount of from 0.001% to 2.5% by weight, preferably from 0.005% to 1.5% by weight based on the amount of reactants.

Stabilizers or polymerization inhibitors may optionally be added to the reaction steps to stabilize free-radical polymerization. Polymerization inhibitors are added to reaction mixtures in amounts of from 0.001 % to 2% by weight, in particular from 0.005% to 1.0% by weight of the reactants. Examples of such inhibitors include, but are not limited to, hydroquinones, or hydroquinone monoalkyl ethers, 2,6-di-tert-butylphenols, such as 2,6-di-tert-butylcresol, nitrosamines, phenothiazines or phosphorous esters.

Free isocyanate (i.e. -N=C=O) reacts with a hydroxyl group from the polymer backbone, or a hydroxyl group from a carboxyl group from the polymer backbone to form a R-NH-C(O)-P linkage where P is the polymer backbone, and R is an organic variable pendent group from the isocyanate group. Specific examples include a urethane group containing compound such as a biuret group containing compound. A free isocyanate that reacts with a primary or secondary amine moiety joined to the polymer backbone forms a R-NH-C(O)-NR¹-G-P urea (carbamide) linkage where R¹ includes, but is not limited to, hydrogen a linear, branched or unsubstituted or substituted alkyl, or an unsubstituted or substituted aryl. Substituent groups include, but are not limited to, halogen, such as fluorine, bromine, chloride or iodine, hydroxyl, carboxyl, or aminyl. A substituent group replaces a hydrogen on a carbon atom. G is an organic moiety that joins the nitrogen to the polymer chain. G includes, but is not limited to, an alkyl, or a substituted aryl
where the nitrogen is joined to the aryl by an alkyl chain. The alkyl of G may be linear or branched (C₁-C₂₄)alkyl. A free isocyanate that reacts with a polyalkoxylated moiety from the polymer backbone forms a R-NH-C(O)-O(AO)ₘ-C(O)-P linkage where A is a linear or branched (C₁-C₂₄)alkyl, and m is an integer from 0 to 1,000, preferably from 1 to 200. R may terminate in one or more functional groups such as ethylenically or acetylenically unsaturated moieties that permit functionalized polymers of the present invention to self cross-link as in photoresist compositions described below.

In one embodiment of the present invention, isocyanate compounds used to prepare the functionalized polymers of the present invention include urethane/ethylenically or acetylenically unsaturated isocyanates. Such compounds have a -NHC(O)- moiety, at least one free isocyanate group, and an ethylenically or acetylenically unsaturated moiety such as a (meth) acrylate that is at a terminsus of the isocyanate compound. Biuret ethylenically or acetylenically unsaturated isocyanates have a -NH-C(O)-N-C(O)-NH- moiety, at least one free isocyanate group and an ethylenically or acetylenically unsaturated moiety at a terminus of the compound. Examples of such compounds include, but are not limited to, the following general formulas:

(II) O=C=N-Z-NH-C(O)-O-Y-O-C(O)-CR²=CH₂;

(III) O=C=N-Z-N[-C(O)-NH-Z-N-C(O)-O-Y-O-C(O)-CR²=CH₂]₂; or

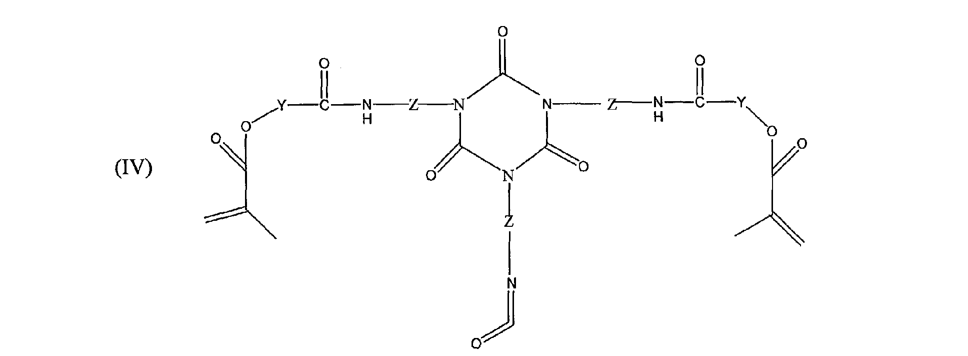

where Z includes, but is not limited to, alkyl, alkylene, cycloalkyl, aryl, heterocyclic alkyl, heteroaryl, a polymer such as a copolymer including a branched polymer or branched copolymer; Y includes, but is not limited to, alky, alkylene, cycloalkyl, aryl, heterocyclic alkyl, heteroaryl, -((CH₂)ₙ-O-)ₒ-(CH₂)ₚ-, or -((CH₂)ₙ-C(O)-O-)ₒ-(CH₂)ₚ-, where n, and p are integers of from 1 to 10, and o is an integer of from 0 to greater than 1,000, preferably from 1 to 200, most preferably from 5 to 10. R² is hydrogen or or (C₁-C₄) alkyl. Preferably R² is hydrogen or methyl. Heteroatoms include, but are not limited to, oxygen, sulfur, and nitrogen. The alkyl, alkylene, cycloalkyl, aryl, heterocyclic alkyl, heteroaryl and polymers may be unsubstituted or substituted. Examples of suitable substitutent groups include, but are not limited to, carboxyl, hydroxyl, (C₁-C₄) alkyl, aminyl such as a primary or secondary aminyl, or hydroxyaminyl, or -CN.

Examples of suitable alkyl groups include, but are not limited to, linear or branched (C₁-C₂₀) alkyl. Examples of alkenyl, cycloakyl or aryl groups include, but are not limited to, linear or branched (C₂-C₂₀) alkenyl, (C₅-C₆) cycloalky such as an isophorone, and (C₅-C₆) aryl such as phenyl.

Functional groups that are to be joined to the polymer backbone and have free reactive groups, such as isocyanate groups, may be reacted with compounds having α,β-ethylenically or acetylenically unsaturated groups to extend the functional pendent groups. Such compounds with unsaturated groups include but are not limited to a compound having a formula:

(V) CH₂=CHR³-C(O)-O-(A₁)-(B₁)-(C₁)-H

where R³ is hydrogen or methyl, (A₁), (B₁) and (C₁) are in any order, (A₁) is a chain formed of from 1 to 40 alkoxylate monomers, aromatic-substituted alkoxylate monomers having from 1 to 20 carbon atoms, or mixtures thereof, (B₁) is either absent or is a chain formed of from 1 to 40 alkoxylate monomers, or aromatic-substituted alkoxylate monomers having from 1 to 20 carbon atoms, or mixtures thereof, and the monomer composition of (B₁) being different than the monomer composition of (A₁), and (C₁) is a chain formed of from 1 to 40 open-ring lactone monomers having from 2 to 21 carbon atoms.

Isocyanate compounds with at least one free isocyanate group may be prepared by any suitable method known in the art. Monoisocyanates, diisocyanates, triisocyanates, or polyisocyanates (four or more free isocyanate groups) that may be employed are either known or may be prepared by analogy to known compounds. Examples of suitable diisocyanates and triisocyanates include, but are not limited to, ethylene diisocyanate, propylene diisocyanate, butylene-1,3-diisocyanate, 1,6-hexamethylene diisocyanate, 2,2,4-trimethyl-hexamethylene diisocyanate, 2,4-dimethyl-6-ethyloctamethylene diisocyanate, cyclohexylene diisocyanate, cyclopentylene diisocyanate, 1,4-diisocyanatomethyl-cyclohexane, 1,3-diisocyanatoethyl-cyclohexane, toluylene diisocyanate, 3,3,5-trimethyl-1-isocyanato-5-isocyanatomethyl-cyclohexane, 2-butene-1,4-diisocyanate, isophorone diisocyanate, 1,6-hexamethylene diisocyanate biuret, 1,6-hexamethylene diisocyanate trimer, isophorone diisocyanate trimer, bis phenol A dimethacrylate capped with 2-hydroxethylmethacrylate capped with 1,6-hexamethylene diisocyanate trimer, and the like. Many of the foregoing listed diisocyantes and triisocyantes as well as the biurets and trimers may be purchased from Lyondell (located at 122 Melanney St., Houston, TX) or Bayer (located at 100 Bayer Rd., Pittsburg, PA 15025).

Isocyanates described above may then be reacted with a sufficient amount of one or more hydroxyl containing compounds, such as compounds of formula (V) above, such that one free isocyanate group is left to react with the main chain prepared as described above. As mentioned above, the reaction mole ratio of hydroxyl group to isocyanate group is 1:1. Any suitable compound with at least one free hydroxyl group to react with an isocyanate group may be employed. An isocyanate compound of the present invention also may be reacted with another isocyanate compound having at least one free hydroxyl group. Hydroxyalkyl, hydroxyalkenyl, hydroxyaryl compounds and the like are examples of such compounds that may be employed. Hydroxyalkyl (meth)acrylates are one example of suitable compounds. Hydroxyethyl (meth)acrylate or hydroxypropyl (meth)acrylate (n or iso compounds) are examples of hydroxyl group-containing esters that are suitable. Other suitable hydroxyalkyl (meth)acrylates include, but are not limited to, 2-hydroxy-butyl (meth)acrylate, 4-hydroxy-butyl (meth)acrylate, 2-hydroxy-cyclohexyl (meth)acrylate, 2-hydroxyethylmethacrylate, and the like. Suitable polyethylene glycol mono (meth)acrylates also may be employed such as, but not limited to, diethylene glycol mono (meth)acrylate, triethylene glycol mono (meth)acrylate and the like. Hydroxyalicyclic (meth)acrylates, and hydroxyaromatic (meth)acrylates such as bis phenol A dimethacrylate also may be employed. U.S. Pat. No. 4,019,972 discloses a method of preparing urethanes that may be employed to practice the present invention.

The functionalized polymers have an average molecular weight range of from about 5,000 daltons to over 50,000 daltons. The functionalized polymers of the present invention may be functionalized with one or more pendent functional moiety in ranges of from 1.0 to as high as 100 mole percent of reactive sites on the polymer backbone, preferably from 25 to 65 mole percent, most preferably from 35 to 55 mole percent. Complete functionalization of the polymer backbone is not always desirable because such groups as hydroxyl and carboxyl groups provide for solubility in aqueous alkaline solutions. Such solubility or hydrophilic character is highly desirable when the functionalized polymer is employed in photoresist. Acid values of the functionalized polymers range from at least 25 mg of potassium hydroxide/gram of polymer, preferably from at least 90 mg, more preferably from at least 120 mg, and most preferably up to 300 mg. Typical acid number ranges are from 50 mg to 250 mg.

The functionalized polymers of the present invention may be employed in both primary imaging photoresists or in secondary imaging photoresists such as in solder masks. The functionalized polymers may act as both the binder polymer for the photoresist as well as the sole cross-linking agent in the photoresist composition. However, cross-linking monomers or oligomers may optionally be added to the photoresist composition. Functionalized polymers of the present invention compose from 30% by weight to 95% by weight of the photoresist composition. Preferably the functionalized polymers comprise from 55% by weight to 95% by weight, most preferably from 75% by weight to 95% by weight of the photoresist composition. The balance of the photoresist composition may include conventional additives as described below.

Optional cross-linking agents that may be employed include a monomer, or a short chain oligomer having ethylenic unsaturation, particularly, α,β-ethylenic unsaturation functionality of 2 or greater. A mixture of monofunctional and multi-functional monomers may be used. Examples of monomers suitable for photoinitiated polymerizatioin include, but are not limited to, (meth)acrylic acid, maleic acid, fumaric acid, citraconic acid, 2-acrylamido-2-methylpropanesulfonic acid, 2-hydroxyethyl acrylol phosphate, 2-hydroxypropyl acrylol phosphate, 2-ethyl hexyl acrylate, n-butyl acrylate, n-hexyl acrylate, methyl (meth)acrylate, hydroxy ethyl acrylate, butyl (meth)acrylate, octyl acrylate, 2-ethoxy ethyl (meth)acrylate, t-butyl acrylate, 1,5-pentanediol di(meth)acrylate, N,N-diethylaminoethyl acrylate, ethylene glycol diacrylate, 1,3-propanediol di(meth)acrylate, decamethylene glycol di(meth)acrylate, 1,4-cyclohexanediol diacrylate, 2,2-dimethylol propane diacrylate, glycerol diacrylate, tripropylene glycol diacrylate, glycerol triacrylate, 2,2-di(p-hydroxyphenyl)-propane dimethacrylate, triethylene glycol diacrylate, polyoxyethyl-2-2-di(p-hydroxyphenyl)-propane dimethacrylate, triethylene glycol dimethacrylate, polyoxypropyltrimethylol propane triacrylate, ethylene glycol dimethacrylate, butylene glycol dimethacrylate, butylene glycol dimethacryalte, 1,2,4-butanetriol trimethacrytlate, 2,2,4-triemthyl-1,3-pentanediol dimethacrylate, pentaerythritol trimethacrylate, 1-phenyl ethylene-1,2-dimethacrylate, pentaerythritol tetramethylacrylate, trimethylol propane trimethacrylate, 1,4-benzenediol dimethacrylate; styrene and alkyl- and aromatic-substituted styrene, such as 2-methyl styrene and vinyl toluene and vinyl esters, such as vinyl (meth)acrylate. Also useful are (meth)acrylate terminated urethane oligomers prepared from hydroxy functional mono(meth)acrylates such as those described in U.S. Pat. No.5,744,282. The optional monomers or oligomers are included in the photoresists of the present invention in reduced amounts from conventional photoresists. Cross-linking monomers may be included in amounts from 5% to 20% by weight of the composition. Preferably such monomers are left out of the photopolymerizable compositions.

To initiate cross-linking of the functionalized polymers of the present invention or the optional monomers or oligomers upon exposure to actinic radiation, the photoimageable compositions of the present invention contain a photoinitiator chemical system. The photoinitiator chemical system may contain from between 0.1% to 15% by weight of the photoresist composition. Suitable photoinitiators include, but are not limited to 9-phenylacridine, n-phenylglycine, aromatic ketones (E.g., benzophenone, N,N''tetramethyl-4, 4'-diaminobenzophenone, N,N'-tetraethyl-4,4'-diaminobenzophenon, 4-methoxy-4'-dimethylaminobenzophenone, 3,3'-dimethyl-4-methoxybenzophenone, p,p'-bis(dimethylamino) benzophenone, p,p'-bis(diethylamino)-benzophenone,anthraquinone, 2-ethylanthraquinone, naphthaquinone, phenanthraquinone, benzoins (e.g., benzoin, benzoinmethylether, benzoinethylether, benzoinisopropylether, benzoin-n-butylether, benzoinphenylether, methylbenzoin, ethylbenzoin, and the like), benzyl derivatives (e.g., dibenzyl, benzyldiphenyldisulfide, benzyldimetehylketal (SIC), and the like), acridine derivatives (9-phenylacridine, 1,7-bis(9-acridinyl)heptane, and the like), thioxanthones (2-chlorothioxanthone, 2-methylthioxanthone, 2,4-diethylthioxanthone, 2,4-dimethylthixanthone, 2-isopropylthixanthone, and the like), acetophenones (e.g., 1,1-dichloroacetophenone, p-t-butyldichloro-acetophenone, 2,2-diethoxyacetphenone, 2,2-dimethoxy-2-phenylacetophenone, 2,2-dichloro-4-phenoxyacetopehnone, and the like), 2,4,5-triarylimidazole dimers (e.g., 2-(o-chlorophenyl)-4,5-diphenylimidazole dimer, 2-(o-chlorophenyl)-4,5-di(m-methoxyphenyl imidazole dimer, 2-(o-flurophenyl)-4,5-diphenylimidazole dimer, 2-(o-methoxyphenyl)4,5-diphenylimidazole dimer, 2-(p-methoxyphenyl)-4,5-diphenylimidazole dimer, 2,4-di(p-methoxyphenyl)-5-phenylimidazole dimer, 2-(2,4-dimethoxyphenyl)-4,5-diphenylimidazole dimer, or 2-(p-methylmercaptophenyl)-4,5-diphenylimidazole dimmer). Though not a free-radical generator, triphenylphosphine may be included in the photoinitiator chemical system as a catalyst.

The photopolymerizable compositions may also include one or more plasticizers in amounts of from 0.5% to 10.0% by weight of the composition. Examples of suitable plasticizers include, but are not limited to, phthalate ester (e.g., dibutylphthalate, diheptylphthalate, dioctylphthalate, and diallylphthalate), glycols (e.g., polyethylene glycol, and polypropylene glycol), glycol esters (e.g., triethylene-glycodiacetate, tetraethylene-glycoldiacetate, dipropylene-glycol-dibenzoate), phosphate esters (tricresylphosphate, triphenylphosphate), amides (p-toluenesulfoneamide, benzensulfoneamide, N-n-butylacetoneamide), aliphatic dibasic acid esters (diisobutyl-adipate, dioctyladipate, dimethylsebacate, dioctylazelate, dibutylmalate, triethylcitrate, tributylcitrate, triethylacetylcitrate, tri-n-propylacetylcitrate, tri-n-butylacetylcitrate, butyl-laurate, dioctyl-4,5-diepoxycyclohexane-1,2-dicarboxylate, glycerinetriacetylesters, dipropyleneglycol dibenzoate, polyethyleneglycol 200 dibenzoate, sucrose benzoate, or trioctyl trimellitate.

Photopolymerizable compositions of the present invention may also include a color former. Color formers are employed in amounts of from 0.1 % to 1.0% by weight of the composition. Examples of suitable color formers include, but are not limited to, diphenylamine, dibenzylaniline, triphenylamine, diethylaniline, diphenyl-p-phenylenediamine, p-toluidine, 4,4'-biphenyldiamine, o-chloroaniline, leuco crystal violet, or leuco malachite green.

Additionally, the photoimageable compositions may contain a wide variety of additional components as are well known in the art, including additional polymers, such as those that might be used to effect a final hardened cure of a solder mask, dyes, stabilizers, flexibilizing agents, rheology agents, or fillers. A wide variety of additional polymeric or resin binders may be added to the photoresists. Such additional polymeric binders may include, as polymerized components, one or more acid functional monomers such as (meth)acrylic acid. For example, U.S. Pat. No. 5,952,153 discloses polymeric binders that have sufficient acid functionality to be employed in the photoresists of the present invention. When employed, such polymers may be used in amounts of from 5% to 20% by weight of the photoresist composition.

Processing of the photopolymerizable compositions is by any suitable method employed in the art. For example, a photopolymerizable composition layer, either formed from a liquid composition or transferred as a layer from a dry film, is applied to a substrate, such as a copper surface, of a metal-clad board. Other suitable metals include, but are not limited to, copper alloys, nickel, tin, zinc, gold, silver, platinum, or palladium. When a liquid photoresist composition is used, it may be applied to a substrate by any known means, such as spinning, dipping, roller coating and the like. When a dry film is used, the dry film is composed of a liquid photoimageable composition dried onto a flexible sheet, e.g., polyethylene terephthalate. Optionally, a protective sheet, e.g., polyethylene, is provided on the surface of the dried photoimageable layer opposite the support sheet before the film is rolled into reels. The protective sheet is removed prior to application, e.g., lamination, to the metal-clad board. Once applied, the photoimageable composition layer is then exposed to actinic radiation through appropriate artwork. Exposure to actinic radiation polymerizes the cross-linking components in the light-exposed areas resulting in a cross-linked structure that is resistant to developer. Next, the composition is developed in dilute alkaline aqueous solution, such as a 1% sodium carbonate solution. The alkali solution causes salt formation with carboxylic acid groups of the functionalized polymer rendering the unexposed portions of the photoresist soluble and removable. After development, an etchant may be used to remove metal from areas where the photoresist was removed thereby forming a printed circuit. The remaining photoresist is then removed using an appropriate stripper, such as 1% to 3% sodium or potassium hydroxide aqueous solution. Organic based developers, such as tetraalkylammonium hydroxide based developers, may be used but are less preferred for the reasons discussed above.

Surprisingly, the present invention provides for a photopolymerizable composition having improved fine line adhesion with faster stripping, and faster strip time with smaller strip mode. Such improvements do not typically occur together in photopolymerizable compositions. Additionally, the particles of photopolymerized material that are stripped are reduced in size in contrast to conventional photopolymerizable material. Particle sizes range from 2 to 30 millimeters. Conventional photoresists have particle sizes from 2 millimeters to large size sheets of meters in size. If strip mode is large, the particles may collect on board manufacturing apparatus wheels and wheel bars contaminating the apparatus. Typically when a photopolymerized material has a fast stripping time the particle size is large. Accordingly, the present invention has unexpected improvements.

Another advantage of the present invention is the elimination or at least reduction in the amount of ethylenically unsaturated monomers that are used in the photopolymerizable composition. The functionalized polymer may be the only cross-linking agent in a photopolymerizable composition. Photopolymerizable processes do not reach 100% conversion. Accordingly, in conventional photoresists free monomer exists in the cured state of the composition. Such monomers may migrate through cover sheets on which a photopolymerizable composition is laminated. The monomers may then act as lubricants causing roll slippage and distortion. Additionally, workers may be exposed to the monomers that have migrated through the cover sheets presenting a toxic hazard. Such migration of monomers may also contaminate artwork employed in lithography. Monomers also may leach into various processing solutions during the manufacture of printed circuit boards and adversely affect the performance of the solutions and the quality of the boards. The monomers may also plasticize dry film photopolymerizable compositions resulting in edge fusion in a dry film roll. The present invention, by reducing or eliminating cross-linking monomers, eliminates or at least reduces the foregoing problems.

Also, compositions that have reduced or no monomer content are easier to waste treat. Conventional waste treatment schemes involve a process in which the pH of the waste treatment stream is lowered by the addition of acid. This causes pH sensitive materials such as polymer binders to precipitate out of solution. The resultant solution becomes clear and free of waste. Monomers typically are not pH sensitive and as a result are more difficult to treat than polymers. Thus, the present invention provides for a more environmentally friendly composition and one which is easier to waste treat because the amount of monomers in the composition is either eliminated or at least reduced.

The following examples are intended to further illustrate the present invention but are not intended to limit the scope of the invention.

### Example 1

### Copolymer 1 Preparation

A homogeneous solution containing 250 grams of methacrylic acid, 100 grams of poly(ethoxylate-b-caprolactone) monomethacrylate with 6 ethoxylations and 650 grams of methyl methacrylate was prepared. 75% by weight of the homogeneous solution were transferred into a second flask. The homogeneous solution of the first flask was diluted to 26.0% by weight solids and the homogeneous solution of the second flask was diluted to 60% by weight solids by adding sufficient methyl ethyl ketone.

The first flask was mixed and heated to reflux under atmospheric conditions. 11 grams of 2,2'-azobis (2-methylbutyronitrile) was added to the reaction mixture, mixed and held at reflux for about 30 minutes.

18 grams of 2,2'-azobis (2-methylbutyronitrile) was mixed with 38.0 grams of methyl ethyl ketone and fed into the first flask along with the contents of the second flask over 4 hours while maintaining reflux. An additional amount of 9.0 grams of methyl ethyl ketone was then added to the first flask and the mixture was refluxed for an additional hour.

15 grams of 2,2'-azobis (2-methylbutyronitrile) were dissolved in 48.0 grams of methyl ethyl ketone and mixed. The mixture was then added to the first flask over a period of 90 minutes while maintaining reflux.

24 grams of 2,2'-azobis (2-methylbutyronitrile) were mixed with 48.0 grams of methyl ethyl ketone and then fed into the reaction mixture over 150 minutes while maintaining reflux. An additional amount of 23.0 grams of methyl ethyl ketone were added to the reaction mixture. At the end of the reaction, 2,2'-azobis (2-methylbutyronitrile) was thermally killed off to below parts per million concentrations. The copolymer formed contained 68.1 mole % of methyl methacrylate, 30.5 mole % of methacrylic acid and 1.4 mole % of poly(ethoxylate-b-cparolactone) monomethacrylate residues. The copolymer was 95.0 % hydroxyl capped.

### Example 2

### Copolymer 2 Preparation

A homogeneous solution containing 250 grams of methacrylic acid, 650 grams of methyl methacrylate and 100 grams of 2-hydroxyethyl methacrylate was prepared. 75% by weight of the homogeneous solution were transferred into a second flask. The homogeneous solution of the first flask was diluted to 25% be weight solids and the homogeneous solution of the second flask was diluted to 60% by weight solids by adding sufficient methyl ethyl ketone.

The first flask was mixed and heated to reflux under atmospheric conditions. 11 grams of 2,2'-azobis (2-methylbutyronitrile) was added to the reaction mixture, mixed and held at reflux for 30 minutes.

18 grams of 2,2'-azobis (2-methylbutyronitirle) was mixed with 40.0 grams of methyl ethyl ketone and fed into the first flask along with the contents of the second flask over 4 hours while maintaining reflux. An additional amount of 10.0 grams of methyl ethyl ketone was then added to the first flask and the mixture was refluxed for an additional hour.

15 grams of 2,2'-azobis (2-methylbutyronitirle) were dissolved in 50.0 grams of methyl ethyl ketone and mixed. The mixture was then added to the first flask over a period of 90 minutes while maintaining reflux.

24 grams of 2,2'-azobis (2-methylbutyronitrile) were mixed with 50.0 grams of methyl ethyl ketone and then fed into the reaction mixture over 150 minutes while maintaining reflux. An additional amount of 20.0 grams of methyl ethyl ketone were added to the reaction mixture. At the end of the reaction, 2,2'-azobis (2-methylbutyronitirle) was thermally killed off to below parts per million concentration. The copolymer formed contained 63.8 mole % of methyl methacrylate, 28.6 mole % of methacrylic acid and 7.6 mole % or 2-hydroxyethyl methacrylate residues. The copolymer was 17.6% hydroxyl capped.

### Example 3

### Copolymer 3 Preparation

A homogeneous solution containing 250 grams of methacrylic acid, 650 grams of methyl methacrylate, and 100 grams of poly(ethoxylated) monomethacrylate with 6 ethoxylations was prepared. 75% be weight of the homogeneous solution were transferred into a second flask. The homogeneous solution of the first flask was diluted to 25% by weight solids and the homogeneous solution of the second flask was diluted to 60% be weight solids by adding sufficient methyl ethyl ketone.

The first flask was mixed and heated to reflux under atmospheric conditions. 11 grams of 2,2'-azobis (2-methylbutyronitirle) was added to the reaction mixture, mixed and held at reflux for 30 minutes.

18 grams of 2,2'-azobis (2-methylbutyronitrile) was mixed with 40 grams of methyl ethyl ketone and fed into the first flask along with the contents of the second flask over 4 hours while maintaining reflux. An additional amount of 10.0 grams of methyl ethyl ketone was then added to the first flask and the mixture was refluxed for an additional hour.

15 grams of 2,2'-azobis (2-methylbutyronitirle) were dissolved in 50 grams of methyl ethyl ketone and mixed. The mixture was then added to the first flask over a period of 90 minutes while maintaining reflux.

24 grams of 2,2'-azobis (2-methylbutyronitrile) were mixed with 50.0 grams of methyl ethyl ketone and then fed into the reaction mixture over 150 minutes while maintaining reflux. An additional amount of 25.0 grams of methyl ethyl ketone were added to the reaction mixture. At the end of the reaction, 2,2'-azobis (2-methylbutyronitrile) was thermally killed off to below parts per million concentrations. The copolymer was composed of 67.0 mole % of methyl methacrylate, 30.0 mole % methacrylic acid and 3.0 mole % poly(ethoxylated) monomethacrylate residues. The copolymer was 45.1 % hydroxyl capped.

### Example 4

### Copolymer 4 Preparation

A homogeneous solution containing 250 grams of methacrylic acid, 650 grams of methyl methacrylate, 100 grams of 2-hydroxyethyl methacrylate, and 2.0 grams of n-butyl acrylate was prepared. 75% by weight of the homogeneous solution were transferred into a second flask. The homogeneous solution of the first flask was diluted to 26.0% by weight solids and the homogeneous solution of the second flask was diluted to 60% by weight solids by adding sufficient methyl ethyl ketone.

The first flask was mixed and heated to reflux under atmosphereic conditions. 11 grams of 2,2'-azobis (2-methylbutyronitrile) was added to the reaction mixture, mixed and held at reflux for 30 minutes.

18 grams of 2,2'-azobis (2-methylbutyronitrile) was mixed with 40.0 grams of methyl ethyl ketone and fed into the first flask along with the contents of the second flask over 4 hours while maintaining reflux. An additional amount of 9.0 grams of methyl ethyl ketone was then added to the first flask and the mixture was refluxed for an additional hour.

15 grams of 2,2'-azobis (2-methylbutyronitrile) were dissolved in 50.0 grams of methyl ethyl ketone and mixed. The mixture was then added to the first flask over a period of 90 minutes while maintaining reflux.

24 grams of 2,2'-azobis (2-methylbutyronitrile) were mixed with 50.0 grams of methyl ethyl ketone and then fed into the reaction mixture over 150 minutes while maintaining reflux. An additional amount of 23.0 grams of methyl ethyl ketone were added to the reaction mixture. At the end of the reaction, 2,2'-azobis (2-methylbutyronitrile) was thermally killed off to below parts per million concentrations. The copolymer was composed of 59.6 mole % of methyl methacrylate, 28.9 mole % of methacrylic acid, 7.6 mole % 2-hydroxyethyl methacrylate and 3.9 mole % of n-butyl acrylate. The copolymer was 17.4% hydroxyl capped.

### Example 5

### Functional Testing of Photoresists

Two photopolymerizable compositions were prepared using one of copolymers 2 or 4 in each photopolyerizable composition. Each photopolymerizable composition was composed of the components of Table 1.

**Table 1**

| Component | Wt % | Function |
|---|---|---|
| Copolymer 2 or 4 | 66.75 | Polymer Binder |
| Bis A ethoxylate dimethacrylate | 13.67 | Photopolymerizable oligomer |
| Alkylene oxide, mono methacrylate | 10.80 | Photopolymerizable monomer |
| Michler's ethyl ketone | 0.05 | UV absorber |
| Lophine dimmer (bis-chlorimidazole) | 3.50 | Color activator/photoinitiator |
| Leuco crystal violet | 0.40 | Color formor |
| Malachite green | 0.05 | Dye |
| Phthalate | 4.48 | Plasticizer |
| Benzophenone | 3.0 | Photoinitiator |
| Modaflow@ | 0.10 | Flow control agent |

Each composition was prepared in 7:1 2-butanone:2-propanol at 50% solids. Each solution was coated onto separate biaxially orientated 80 gauge polyester films and dried to 1% or less retained solvent. The coated mixtures were then laminated onto mechanically scrubbed 1 oz/FR-4/1 oz clad copper composite using a hot roll laminator at 110° C at 2 meters/minute and 3 bar pressure.

Breakpoint in seconds was determined for each of the photopolymerizable compositions. The developer employed was a 1% by weight sodium carbonate monohydrate aqueous solution. The time measured was the time each coated panel took to reach the 50% point in the conveyorized spray developer. Results for each copolymer are in Table 2 below.

A second set of laminated materials with each type of copolymer were then imaged on a UV printer through an appropriate phototool with an adjusted exposure to obtain a copper step of 7 as measured with a Stouffer® 21 step wedge (exposure unit settings varied as shown in Table 2). The exposed panels were then tested for both fine line adhesion (stress test for adhesion) and cross-hatch adhesion (macroscopic observation of adhesion with a scale of 1-5 with 5 being the best adhesion) of the photopolymerized compositions. The exposed panels were then developed in a 1% sodium carbonate monohydrate solution at 30° C using a conveyorized spray developer at 26 psi with residence time adjusted such that the break point occurred at 50% of the chamber length, followed by several spray rinses using deionized water.

Etching was accomplished using a 2N cupric chloride/hydrochloric acid solution at 45° C in a conveyorized etcher equipped with multiple spray nozzles. The etch resolution of each photopolymerized composition was measured using a scanning electron micrograph (SEM). The etched boards were then stripped of the imaged, developed and etched photopolymerized compositions in a 3% by weight sodium hydroxide solution as 52° C in a conveyorized stripping unit equipped with multiple spray nozzles followed by a spray rinse of deionized water. The stripping time and mode of each photopolymerized composition was recorded as shown in Table 2.

**Table 2**

| **Copolymer In Photoresist** | **B.P. (Sec)** | **Exposure Unit Setting** | **Etch Resolution (microns)** | **Plating Resolution (microns)** | **Fine Line Adehsion (microns)** | **Cross Hatch Adesion (5=best)** | **Developed Sidewall (10=best)** | **Strip Time (sec)** | **Strip Mode (mm)** | **Residue (mg)** |
|---|---|---|---|---|---|---|---|---|---|---|
| 2 | 29 | 24 | 80 | 35 | 80 | 4 | 1 | 29 | 20-30 | 17.4 |
| 4 | 19 | 14 | 60 | 30 | 60 | 5 | 4 | 30 | 5-10 | 4.9 |

The two copolymers of the present invention had good fine line adhesion values, good cross hatch adhesion values, good strip times for removing cured photopolymerized material from the panels and good plating resolution.

Copolymer 4 which contained n-butyl acrylate showed side wall improvement over copolymer 2 which contained 2-hydroxyethyl methacrylate as well as reduced residue deposit. Thus, the addition of an n-butyl acrylate monomer to the copolymer binder further improved the properties of the photoresist of the present invention.

Unexpectedly, the compositions of the present invention showed good fine line adhesion with good plating resolution, good adhesion with fast stripping, and a fast stripping time with a low strip mode. Accordingly, The compositions of the present invention provide an improved binder material and photoresist.

### Example 6

### Synthesis of Functionalized Copolymer

A homogeneous solution containing 197 grams of methacrylic acid, 512 grams of methyl methacrylate and 79 grams of poly(ethoxylated) monomethacrylate was prepared. 75% by weight of the homogeneous solution were prepared into a second flask. The homogeneous solution of the first flask was diluted to 25% by weight solids and the homogeneous solution of the second flask was diluted to 60% be weight solids by adding sufficient methyl ethyl ketone.

The first flask was mixed and heated to reflux under atmospheric conditions. 2.0 grams of 2,2'-azobis (2-methylbutyronitirle) was added to the reaction mixture, mixed and held at reflux for 30 minutes.

6.0 grams of 2,2'-azobis (2-methylbutyronitirle) was mixed with about 40 grams of methyl ethyl ketone and fed into the first flask along with the contents of the second flask over 4 hours while maintaining reflux. An additional amount of 9.0 grams of methyl ethyl ketone was then added to the first flask and the mixture was refluxed for an additional hour.

5.0 grams of 2,2'-azobis (2-methylbutyronitrile) were dissolved in 50.0 grams of methyl ethyl ketone and mixed. The mixture was then added to the first flask over a period of 90 minutes while maintaining reflux.

9.0 grams of 2,2'-azobis (2-methylbutyronitrile) were mixed with 50.0 grams of methyl ethyl ketone and then fed into the reaction mixture over 150 minutes while maintaining reflux. An additional amount of 25.0 grams of methyl ethyl ketone were added to the reaction mixture. At the end of the reaction, 2,2'-azobis (2-methylbutyronitirle) was thermally killed off to below parts per million concentrations. The acrylic copolymer main chain or backbone was set aside.

5.31 grams of 1,6-hexamethylene diisocyanate biuret (23.% free-NCO) were added to a clean dry, nitrogen sparged flask. 0.06 grams of dibutylin dilaurate, 0.05 grams of Irganox® 1076 (antioxidant) and 160.0 grams of methyl ethyl ketone were also added to the flask. The flask was sparged with dry air and stoppered. The components were mixed and heated at 35° C.

In a separate clean dry air sparged addition funnel, 15.97 grams of poly(ethoxylate-b-caprolactone) monomethacrylate oligomer was weighed out. The oligomer was added to the flask containing the 1,6-hexamethylene diisocyanate biuret over 1 hour with mixing and maintaining a temperature of 35° C. The addition funnel was then rinsed with 118.0 grams of methyl ethyl ketone to remove any remaining oligomer. The rinse was added to the flask containing the biuret with a temperature increased to 60° C. The reaction was maintained for 3 hours at 60° C. the reaction was monitored to determine completion of the synthesis of a urethane acrylate moiety by high pressure liquid chromatography (HPLC).

The functionalized polymer was prepared by weighing out 763.0 grams of the acrylic copolymer (47% solids) and 50.0 grams of methyl ethyl ketone to a clean, dry air sparged flask. The combination was mixed and heated to 45° C. The urethane/acrylate moiety was then added to the acrylic polymer over 1 hour 0.50 grams of Irganox® 1076 and 30.0 grams of methyl ethyl ketone was added to the reaction mixture. The reaction contents were held at 45° C for 3 hours with constant mixing. The resulting copolymer was composed of 25 mole % of methyacrylic acid, 65 mole % of methyl methacrylate and 10 mole % of poly(ethoxylated) monomethacrylate residues. The copolymer main chain was 6 mole% functionalized with the moiety.

### Example 7

### Synthesis of a Functionalized Copolymer

A homogeneous solution containing 77.5 grams of 2-hydroxyethyl methacrylate, 194 grams of methacrylic acid, and 504 grams of methyl methacrylate was prepared. 75% by weight of the homogeneous solution was transferred to a second flask. The homogeneous solution of the first flask was diluted to 25% by weight solids and the homogeneous solution of the second flask was diluted to 60% by weight solids by adding sufficient methyl ethyl ketone.

The first flask was mixed and heated to reflux under atmospheric conditions. 2.0 grams of 2,2'-azobis (2-methylbutyronitirle) was added to the reaction mixture, mixed and held at reflux for 30 minutes.

6.25 grams of 2,2'-azobis (2-methylbutyronitirle) was mixed with 40.0 grams of methyl ethyl ketone and fed into the first flask along with the contents of the second flask over 4 hours while maintaining reflux. An additional amount of 9.0 grams of methyl ethyl ketone was then added to the first flask and the mixture was refluxed for an additional hour.

5.0 grams of 2,2'-azobis (2-methylbutyronitrile) were dissolved in 50.0 grams of methyl ethyl ketone and mixed. The mixture was then added to the first flask over a period of 90 minutes while maintaining reflux.

9.0 grams of 2,2'-azobis (2-methylbutyronitirle) were mixed with 50.0 grams of methyl ethyl ketone and then fed into the reaction mixture over 150 minutes while maintaining reflux. An additional amount of 23.0 grams of methyl ethyl ketone were added to the reaction mixture. At the end of the reaction, 2,2'-azobis (2-methylbutyronitirle) was thermally killed off to below parts per million concentrations. The acrylic polymer main chain or backbone product was set aside.

150.0 grams of 1,6-hexamethylene diisocyanate biuret (23.0% -NCO) were added to a clean dry, nitrogen sparged flask. 0.06 grams of dibutylin dilaurate, 0.05 grams of Irganox® 1076 (antioxidant) and 160.0 grams of methyl ethyl ketone were also added to the flask. The flask was sparged with dry air and stoppered. The components were mixed and heated at 35° C.

In a separate clean dry air sparged addition funnel, 190.0 grams of poly(ethoxylate-b-caprolactone)monomethacrylate oligomer was weighed out. The oligomer was added to the flask containing the 1,6-hexamethylene diisocyanate biuret over 1 hour with mixing and maintaining a temperature of 35° C. The addition funnel was then rinsed with 120.0 grams of methyl ethyl ketone to remove any remaining oligomer. The rinse was added to the flask containing the biuret with a temperature increased to 60° C. The reaction was maintained for 3 hours at 60° C. The reaction was monitored to determine completion of the synthesis of the urethane acrylate moiety.

The functionalized polymer was prepared by weighing out 750.0 grams of the acrylic copolymer and 55.0 grams of methyl ethyl ketone to a clean, dry air sparged flask. The combination was mixed and heated to 45° C. The urethane/arcrylate moiety was then added to the acrylic copolymer over 1 hour. 0.50 grams of Irganox® 1076 and 30.0 grams of methyl ethyl ketone was added to the reaction mixture. The reaction contents were held at 45° C for 3 hours with constant mixing. The polymer main chain was 6 mole percent functionalized with the moiety.

### Example 8

### Preparation of a Printed Circuit Board

Functionalized copolymers from Examples 7 and 8 are used to prepare two separate photoimageable compositions disclosed in the table below.

**Table 3**

| Component | Wt % | Function |
|---|---|---|
| Example 6 or Example 7 | 91.22 | Polymer Binder |
| Michler's ethyl ketone | 0.05 | UV absorber |
| Lophine dimmer (bis-chlorimidazole) | 3.50 | Color activator/photoinitiator |
| Leuco crystal violet | 0.40 | Color formor |
| Malachite green | 0.05 | Dye |
| Phthalate | 4.48 | Plasticizer |
| Benzophenone | 3.0 | Photoinitiator |
| Modaflow® | 0.10 | Flow control agent |

Each photopolymerizable composition is prepared in a 7:1 2-butanone:2-propanol at 50% solids. The solutions are coated onto separate biaxially orientated 80 gauge polyester films and dried to 1% or less retained solvent. The coated mixtures are then laminated onto mechanically scrubbed FR-4 copper clad composites using a hot roll laminator at 110° C at 2 meters/minute and 3 bar pressure.

The laminated material is then imaged on a UV printer through an appropriate phototool. The exposed composites are developed in a 1% sodium carbonate monohydrate solution at 30° C using a conveyorized spray developer at 26 psi with residence time adjusted so that the break point occurred at 50% of the chamber length followed by several spray rinses using tap water and deionized water.

Etching was accomplished using a 2N cupric chloride/hydrochloric acid solution at 50° C in a conveyorized etcher equipped with multiple spray nozzles. The etched board is then stripped of the imaged developed and etched photopolymerized composition in a 3% sodium hydroxide solution at 55° C in a conveyorized stripping unit equipped with multiple spray nozzles followed by a spray rinse of tap water. The result is a quality printed circuit boards.

## Claims

1. A compound comprising a backbone having a formula:
(A)ᵤ (B)_{y} (C)_{w} (D)ₓ (E)_{y} (F)_{z}
where A is derived from one or more hydroxyl alkyl (meth)acrylate, B is derived from one or more hydroxy polyalkyleneoxide (meth)acrylate, C is derived from one or more alkyl(meth)acrylate, D is derived from one or more (meth)acrylic acid, E is derived from one or more vinyl aromatic monomer, nitrogen containing compound or thio-analog of a nitrogen containing compound, silicon containing monomer, substituted ethylene monomer, or cyclic olefin monomer, and F is derived from one or more hydroxy poly opened-ring lactone polyalkylene oxide (meth)acrylate, where u, v, w, x, y and z are weight percentages of the monomers in the backbone, where u is 0 to 30%, v is 0 to 30%, w is 5 to 70%, x is 5 to 40%, y is 0 to 20% and z is 0 to 30% with the proviso that at least one or u, v or z is greater than 0, and at least one or A, B, C, D, E and F has at least one pendent functional group.

2. The compound of claim 1, wherein the alkyl group has from 1 to 24 carbon atoms.

3. The compound of claim 1, wherein the pendent functional group is derived from a compound that reacts with a hydroxyl group or amine group on the backbone of the copolymer to form a bond, the pendent functional group comprises at least one α,β-ethylenically or acetylenically unsaturated moiety.

4. The compound of claim 3, wherein the pendent functional group is derived from monoisocyanates, diisocyanates, triisocyanates, polyisocyanates, or mixtures thereof.

5. The compound of claim 4, wherein the diisocyanates, triisocyanates or polyisocyanates are bonded through a free isocyanate group to a free hydroxyl group of a compound having a formula:
CH₂=CHR³-C(O)-O-(A₁)-(B₁)-(C₁)-H
wherein R³ is hydrogen or methyl, (A₁), (B₁) and (C₁) are in any order, (A₁) is a chain formed of from 1 to 40 alkoxylate monomers, aromatic-substituted alkoxylate monomers having from 1 to 20 carbon atoms, or mixtures thereof, (B₁) is either absent or is a chain formed of from 1 to 40 alkoxylate monomers, or aromatic-substituted alkoxylate monomers having from 1 to 20 carbon atoms, or mixtures thereof, and the monomer composition of (B₁) being different than the monomer composition of (A₁), and (C₁) is a chain formed of from 1 to 40 open-ring lactone monomers having from 2 to 21 carbon atoms.

6. A photopolymerizable composition comprising:
a) a polymeric binder having a formula:
(A)ᵤ (B)ᵥ (C)_{w} (D)ₓ (E)_{y} (F)_{z}
where A is derived from one or more hydroxyl substituted alkyl (meth)acrylate, B is derived from one or more hydroxy polyalkyleneoxide (meth)acrylate, C is derived from one or more alkyl (meth)acrylate, D is derived from one or more (meth)acrylic acid, E is derived from one or more vinyl aromatic monomer, nitrogen containing compound or thio-analog of a nitrogen containing compound, silicon containing monomer, substituted ethylene monomer, or cyclic olefin monomer, and F is derived from one or more hydroxy poly opened-ring lactone polyalkylene oxide (meth)acrylate where u, v, w, x, y and z are weight percentages of the monomers in the backbone, where u is 0 to 30%, v is 0 to 30%, w is 5 to 70%, x is 5 to 40%, y is 0 to 20% and z is 0 to 30% with the proviso that at least one of u, v or z is greater than 0, and at least one of A, B, C, D, E and F has at least one pendent functional group; and
b) one or more photoinitiators.

7. A method of imaging comprising:
a) providing a photopolymerizable composition comprising:
1) a compound having a formula:
(A)ᵤ (B)ᵥ (C)_{w} (D)ₓ (E)_{y} (F)_{z}
where A is derived from one or more hydroxy substituted alkyl (meth)acrylate, B is derived from one or more hydroxy polyalkylene oxide (meth)acrylate, C is derived from one or more alkyl (meth)acrylate, D is derived from one or more (meth)acrylic acid, E is derived from one or more vinyl aromatic monomer, nitrogen containing compound, silicon containing monomer, substituted ethylene monomer, or cyclic olefin monomer, or thio-anolog of a nitrogen containing compound, and F is one or more poly opened-ring lactone polyalkylene oxide (meth)acrylate, where u, v, w, x, y and z are weight percentages of the monomers in the backbone, where u is 0 to 30%, v is 0 to 30%, w is 5 to 70%, x is 5 to 40%, y is 0 to 20% and z is 0 to 30% with the proviso that at least one of u, v or z is greater than 0, and at least one of A,B,C, D, E and F has at least one pendent functional group, and
2) one or more photoinitiators;
b) applying the photopolymerizable compositioin to a substrate;
c) imagewise exposing the photopolymerizable composition to actinic radiation to form a polymerized composition; and
d) developing the imagewise exposed photopolymerized compositon to form an image on the substrate.

8. The method of claim 7, further comprising a step of etching away metal on the substrate exposed during developing.

9. The method of claim 8, further comprising the step of stripping away the photopolymerized composition from the developed and etched board to form a printed circuit board.

10. The method of claim 9, wherein the metal on the substrate comprises copper, copper alloy, nickel, gold, platinum, silver, tin, zinc, or palladium.
